(19) Europäisches Patentamt
European Patent Office
Office européen des brevets

(11) Veröffentlichungsnummer: **0 301 332 B1**

(12) **EUROPÄISCHE PATENTSCHRIFT**

(45) Veröffentlichungstag der Patentschrift: **16.03.94**

(51) Int. Cl.[5]: **G03F 7/022**

(21) Anmeldenummer: **88111371.6**

(22) Anmeldetag: **15.07.88**

(54) **Positiv-Fotoresist-Zusammensetzungen.**

(30) Priorität: **27.07.87 DE 3724791**

(43) Veröffentlichungstag der Anmeldung:
**01.02.89 Patentblatt 89/05**

(45) Bekanntmachung des Hinweises auf die Patenterteilung:
**16.03.94 Patentblatt 94/11**

(84) Benannte Vertragsstaaten:
**AT CH DE FR GB IT LI NL SE**

(56) Entgegenhaltungen:
**EP-A- 0 050 802**
**EP-A- 0 295 465**
**GB-A- 1 494 640**

**PATENT ABSTRACTS OF JAPAN, Band 9, Nr. 323 (P-414)[2046], 18. Dezember 1985; & JP-A-60 150 047**

(73) Patentinhaber: **CIBA-GEIGY AG**
**Klybeckstrasse 141**
**CH-4002 Basel(CH)**

(72) Erfinder: **Schulz, Reinhard, Dr.**
**Im Trappengrund 44**
**D-6107 Reinheim(DE)**
Erfinder: **Münzel, Horst, Dr.**
**Rüdesheimer Strasse 20**
**D-6100 Darmstadt(DE)**

**EP 0 301 332 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Positiv-Fotoresist-Zusammensetzunen, die bestimmte aromatische Hydroxyverbindungen enthalten und die Verwendung der genannten Verbindungen zur Steigerung der Fotoempfindlichkeit ("Photospeed") und/oder der Entwicklungsrate ("Rate of Development") sowie des Kontrastes.

Die Herstellung von Halbleiterbauelementen und integrierten Schaltungen in der Mikroelektronik erfolgt praktisch ausschließlich unter Anwendung photolithographischer Strukturierungsprozesse. Zur Herstellung von bestimmte Schaltungsstrukturen aufweisenden Mikrochips wird das Halbleitersubstratmaterial, im allgemeinen sind das Siliziumscheiben, mit Fotolack beschichtet und durch bildmäßiges Belichten und anschließendes Entwickeln werden hierauf Fotoresist-Reliefstrukturen erzeugt. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Nach diesen Prozessen werden die Fotoresist-Masken je nach Bedarf wieder entfernt. Durch eine Vielzahl derartiger Prozeßzyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozeß abgelost, während die unbelichteten Bereiche als Schicht auf dem Substrat verbleiben. Bei negativ arbeitenden Fotoresists verbleiben umgekehrt die bestrahlten Schichtbereiche als Reliefstruktur. Positiv-Fotoresists besitzen von ihrer Natur her eine höhere Bildauflösung und werden deshalb überwiegend bei der Herstellung von VLSI-Schaltungen eingesetzt.

Positiv-Fotoresist-Zusammensetzungen üblicher Art enthalten in einem organischen Lösungsmittel im wesentlichen mindestens je ein in wäßrigen Alkalien lösliches Harz und eine fotoempfindliche Chinondiazidverbindung, die die Alkalilöslichkeit des Harzes reduziert. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, sodaß nach Entwicklung in wäßrig-alkalischen Entwicklungsbädern positive Fotoresist-Reliefstrukturen erhalten werden.

Die für die technische Anwendbarkeit wesentlichen Merkmale eines Fotoresist sind Strahlungsempfindlichkeit, Bildauflösung und Kontrast.

Eine hohe Empfindlichkeit ist wichtig, um in den produktionstechnischen Prozeßzyklen kurze Bestrahlungszeiten zu gewährleisten, auch etwa, wenn gerätetechnisch bedingt nur Strahlung geringerer Intensität auf den Resist einwirken kann.

Die Bildauflösung charakterisiert, bis zu welchen Dimensionen kleinste Bildstrukturen, wie etwa Linien und Zwischenräume, klar getrennt durch den Fotoresist wiedergegeben werden können. Die Herstellung von VLSI-Schaltungen erfordert die Wiedergabe von Strukturdetails in der Größenordnung von 1 $\mu$m und weniger.

Der Kontrast charakterisiert die Kantensteilheit und Kantenschärfe der nach der Entwicklung erhaltenen Fotoresist-Reliefstrukturen.

Die ständig fortschreitende Miniaturisierung in der Halbleitertechnologie und Mikroelektronik stellt an die Fotoresist-Materialien und die damit darzustellenden Reliefstrukturen höchste Anforderungen, insbesondere hinsichtlich Empfindlichkeit, Auflösung und Kontrast, aber auch an die Haftfestigkeit, mechanische und chemische Stabilität, Dimensionstreue und Beständigkeit bei erhöhten Temperaturen oder anderen Einflüssen, die bei den weiteren Prozeßschritten auf die Fotoresist-Reliefstrukturen einwirken können.

Zu diesem Zweck enthalten die gängigen Positiv-Fotoresists neben den Basiskomponenten alkalilösliches Harz und Chinondiazidverbindung meist auch die verschiedensten Zusatzstoffe, um die Eigenschaften des Fotoresist hinsichtlich der genannten Anforderungen zu optimieren. So sind beispielsweise als empfindlichkeitssteigernde Additive aus den US-Patenten 3,661,582 und 4,365,019 Stickstoffheterozyklen-Verbindungen wie Benzotriazol oder halogenierte Benzotriazol-Derivate bekannt. Gemäß den US-Patenten 4,036,644 bzw. 4,115,128 werden für den gleichen Zweck aliphatische Verbindungen mit einer oder mehreren Carboxylgruppen bzw. organische zyklische Anhydride eingesetzt. Als besonders effektive Zusätze zur Steigerung der Empfindlichkeit und der Entwicklungsrate werden in dem US-Patent 4,626,492 Trihydroxybenzophenone beschrieben, insbesondere die Verbindung 2,3,4-Trihydroxybenzophenon. Aber auch diese Verbindungen vermögen die steigenden Anforderungen nicht zu befriedigen. Der Effekt der Steigerung der Entwicklungsrate durch Zusätze, die hydrophile oder saure Gruppen aufweisen, wie es etwa bei polyhydroxylierten Benzolderivaten der Fall ist, beruht im wesentlichen auf einer Erhöhung der Löslichkeit des Harzes in wäßrig-alkalischen Medien. Der Zusatz von undifferenziert die Löslichkeit steigernden Additiven zum Fotoresist wie auch die Verwendung von schnelleren Entwicklern höherer Ionenkonzentration hat jedoch den Nachteil, daß es bei der Entwicklung auch zu einem verstärkten Angriff

der unbelichteten Resistbereiche kommt. Hierdurch wird der Dunkelabtrag vergrößert, d.h. die Schichtdicke der verbleibenden Fotoresist-Reliefstrukturen wird vermindert. Des weiteren wird die Differenzierung der Löslichkeit zwischen belichteten und unbelichteten Bereichen schlechter, was zu einer Verringerung des Kontrastes, also einer Verminderung der Kantensteilheit und Kantenschärfe und damit der Abbildungsgualität führt.

In der GB-A-1 494 640 ist ein lichtempfindliches Gemisch beschrieben, das ein alkalilösliches Bindemittel, eine Chinondiazidverbindung und beispielsweise Bisphenol Azur Umkehr der Arbeitscharakteristik des Resists enthält.

Aus der EP-A-0 050 802 ist ein lichtempfindliches Gemisch bekannt, das ein in wässerigem Alkali lösliches Harz und eine fotoempfindliche Chinondiazidverbindung sowie eine weitere Verbindung mit beispielsweise zwei Benzolkernen enthält, die über eine Einfachbindung oder über eine Carbonyl-, Ether- oder Thioethergruppe verbunden sind und die beispielsweise auch zwei und mehr Hydroxylgruppen aufweisen kann. Diese Verbindungen müssen aber mindestens zwei Reste der Formel $-CH_2OR$ aufweisen und dienen zur thermischen Härtung der Schicht. So kann es sich z. B. um entsprechende 4,4'-Dihydroxybisphenylderivate handeln.

Aus Patent Abstracts of Japan, Band 9, Nr. 323 (P-414) [2046], 18. Dezember 1985, der die JP-A-60 150 047 (Fujishashin Film K. K.) betrifft, ist ein positiv arbeitendes Photoresistgemisch auf Basis von Chinondiazidverbindungen bekannt, das zur Steigerung der Lichtempfindlichkeit eine Bisphenylverbindung enthält, deren Phenylgruppen über Alkylengruppen verbunden sind.

Weiterhin sind in der nicht vorveröffentlichten EP-A-0 295 465, die auf eine prioritätsältere europäische Patentanmeldung mit Benennung der Vertragsstaaten CH, DE, ES, FR, GB, IT, LI und NL zurückgeht, noch positiv arbeitende Photoresistgemische auf Basis von Chinondiazidverbindungen und von wässerig-alkalisch löslichen Phenolharzen beschrieben, die als Additiv zur Steigerung der Empfindlichkeit 4,4'-Dihydroxybiphenyl, 4,4'-Dihydroxybenzophenon, Bis(4-hydroxyphenyl)sulfid oder Bis(4-hydroxyphenyl)sulfon enthalten.

Der vorliegenden Erfindung liegt die Aufgabe zugrunde, weitere Additive für Positiv-Fotoresists aufzufinden, die die Fotoempfindlichkeit und/oder Entwicklungsrate merklich steigern, ohne aber dabei die Abbildungsqualität zu beeinträchtigen. Weiterhin sollten Positiv-Fotoresistformulierungen, die solche Additive enthalten, entwickelt werden, die bezüglich Fotoempfindlichkeit bzw. Entwicklungsrate sowie bezüglich Kontrast und verbleibender Schichtdicke der damit erzeugten Fotoresist-Reliefstrukturen überlegen sind.

Überraschend wurde nun gefunden, daß Verbindungen der Formel I

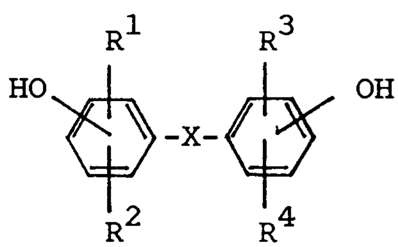

(I)

worin

X eine Einfachbindung, -O-, -S-, $SO_2$, CO,

$R^1$, $R^2$, $R^3$, $R^4$ jeweils H, Halogen, $C_{1-4}$-Alkyl, $C_{1-4}$-Alkoxy oder OH unter Ausschluß aller Trihydroxybenzophenon-Verbindungen

bedeuten, vorzüglich als derartige Additive geeignet sind.

Gegenstand der Erfindung sind somit Positiv-Fotoresist-Zusammensetzungen, enthaltend in einem organischen Lösungsmittel im wesentlichen mindestens je

a) ein alkalilösliches Harz

b) eine fotoempfindliche Chinondiazid-Verbindung

c) eine die Fotoempfindlichkeit und/oder die Entwicklungsrate steigernde aromatische Hydroxyverbindung,

sowie gegebenenfalls weitere übliche Zusatzstoffe, in denen als aromatische Hydroxyverbindung eine Verbindung der Formel I enthalten ist.

Gegenstand der Erfindung sind weiterhin die Verwendung der Verbindungen der Formel I als Additive zur Steigerung der Fotoempfindlichkeit und/oder der Entwicklungsrate sowie des Kontrasts in Positiv-Fotoresist-Zusammensetzungen auf Basis alkalilöslicher Harze und lichtempfindlicher Chinondiazid-Verbindungen.

Die erfindungsgemäßen Positiv-Fotoresist-Zusammensetzungen entsprechen bezüglich der Hauptkomponenten im wesentlichen den bekannten und handelsüblichen Positiv-Fotoresists. Sie enthalten in einem organischen Lösungsmittel ein alkalilösliches Harz, eine fotoempfindliche Chinondiazid-Verbindung und gegebenenfalls weitere übliche Zusatzstoffe, mit denen die Eigenschaften des Fotoresist auf die spezifischen Anforderungen der Einsatzzwecke eingestellt werden können.

Erfindungsgemäß enthalten die Positiv-Fotoresist-Zusammensetzungen zur Steigerung der Empfindlichkeit und/oder der Entwicklungsrate mindestens eine aromatische Hydroxy-verbindung der Formel I. Die Verbindungen der Formel I sind Bisphenyl-Verbindungen, in denen jeder Phenylring mindestens eine Hydroxygruppe trägt und in denen die beiden Phenylringe über eine Brücke X, die eine Einfachbindung, eine Sauerstoff-, Schwefel-, Sulfon-, Carbonyl gruppe darstellen kann,verknüpft sind. Die Reste $R^1$, $R^2$, $R^3$ und $R^4$ können, sofern sie nicht Wasserstoff bedeuten, Halogen wie Fluor, Chlor, Brom, $C_{1-4}$-Alkyl wie Methyl, Ethyl, n- oder i-Propyl, n-, i-, t-Butyl, $C_{1-4}$-Alkoxy wie Methoxy, Ethoxy, n-, i-Propoxy, n-, i-, t-Butoxy sowie OH sein, wobei aber alle Trihydroxybenzophenon-Verbindungen ausgeschlossen sind. Vorzugsweise enthalten die Verbindungen der Formel I zwei oder vier OH-Gruppen und sonst keine weiteren Substituenten. Die OH-Gruppen besetzen bevorzugt die 4,4'-, die 2,2'-, oder die 2,2',4,4'-Positionen. Bevorzugte Additive im Sinne der Erfindung sind etwa die Verbindungen 4,4'-Dihydroxybiphenyl, 2,2'-Dihydroxybiphenyl, 4,4'-Dihydroxybenzophenon, Bis(4-hydroxyphenyl)ether, Bis(4-hydroxyphenyl)sulfid, Bis-(2,4-dihydroxyphenyl)sulfid, Bis(4-hydroxyphenyl)sulfon, Besonders bevorzugt sind Bis(4-hydroxyphenyl)-sulfon, 4,4'-Dihydroxybenzophenon und Bis(2,4-dihydroxyphenyl)sulfid.

Als besonders überraschend stellte sich heraus, daß die Verbindungen der Formel I in der Summe ihrer Eigenschaften den aus US-Patent 4,626,492 bekannten Trihydroxybenzophenon-Additiven überlegen sind. So läßt sich mit den Verbindungen der Formel I in unerwartet verstärktem Maße die Mindestbelichtungsenergie senken und/oder der Kontrast steigern und/oder der Dunkelabtrag reduzieren. In den meisten Fällen sind die Verbindungen der Formel I bei mindestens zweien oder in allen diesen Kriterien den Trihydroxybenzophenonen überlegen. Die sonstigen Eigenschaften der Positiv-Fotoresists wie etwa Haftfestigkeit, Temperaturbeständigkeit, Plasma-Ätzresistenz werden durch den Zusatz von Verbindungen der Formel I nicht negativ beeinflußt. Die Verbindungen der Formel I sind ab einem Gehalt von etwa 2 Gew.%, bezogen auf den Gesamtfeststoffgehalt der Fotoresistlösung, wirksam. Ein Gehalt von über 25 Gew.% bringt kaum mehr Vorteile und ist nicht mehr wirtschaftlich.

Die erfindungsgemäßen Positiv-Fotoresist-Zusammensetzungen enthalten als Harzkomponente alkalilösliche Harze wie zum Beispiel Novolak-Harze, die durch Kondensation von Phenol bzw. phenolischen Verbindungen mit Aldehyden erhalten werden. Bevorzugt sind Kresol-Formaldehyd-Harze, zu deren Herstellung o-, m-, p-Kresol oder Mischungen dieser Isomeren in beliebigen oder vorbestimmten Verhältnissen eingesetzt werden. Die Herstellung solcher Harze und ihr Einsatz in Positiv-Fotoresists ist z.B. in US-Patent 4,377,631 beschrieben. In Positiv-Fotoresist-Zusammensetzungen ist die Harzkomponente üblicherweise in einem Anteil von etwa 50-95 Gew.%, bezogen auf den Gesamtfeststoffgehalt der Fotoresist-Lösung, enthalten.

Außerdem kommen auch andere alkalilösliche Harze in Frage, wie sie vielfach in Positiv-Fotoresists verwendet werden. Dazu gehören etwa Poly-Vinylphenole und Poly-Glutarimide, Copolymere aus Styrol und $\alpha$-Methylstyrol mit Maleinimid sowie Copolymere aus N-(p-Hydroxyphenyl)-maleinimid und Olefinen. Weiterhin können auch silylierte Derivate alkalilöslicher Polymere verwendet werden, die eine höhere Plasmaätzbeständigkeit aufweisen.

Als fotoempfindliche Chinondiazidverbindungen sind in Positiv-Fotoresists bevorzugt Veresterungsprodukte der 1,2-Naphthochinon-2-diazid-5-sulfonsäure oder 1,2-Naphthochinon-2-diazid-4-sulfonsäure mit niedermolekularen aromatischen oder aliphatischen Hydroxyverbindungen enthalten. Derartige Naphthochinondiazidsulfonsäureester sind beispieisweise in den US-Patentschriften 3,046,112, 3,106,462, 3,148,983 und 3,201,239 sowie in EP 0085761 beschrieben. Überwiegend sind in Positiv-Fotoresists als lichtempfindliche Komponenten Naphthochinondiazidsulfonsäureester von Hydroxybenzophenonen wie insbesondere 2,3,4-Trihydroxybenzophenon im Gebrauch. Vorteilhaft sind auch die entsprechenden Ester mehrfach hydroxylierter Benzole, wie etwa die Isomeren von Trihydroxybenzol, insbesondere 1,3,5-Trihydroxybenzol. Gelegentlich werden auch oligomere oder polymere Naphthochinondiazidverbindungen eingesetzt, in denen etwa der Naphthochinondiazidsulfonylrest mit freien Hydroxyl-Gruppen von Phenolformaldehydkondensaten, also beispielsweise denen des Novolak-Harzes selbst, verestert ist. Von den lichtempfindlichen Naphthochinondiazidverbindungen sind überwiegend die 5-Sulfonsäureester im Gebrauch. Diese verfügen über eine breite Absorption im nahen bis mittleren UV-Wellenlängenbereich mit Maxima bei etwa 400 nm und etwa 340 nm. In diesem Wellenlängenbereich liegen kräftige Emissionslinien der üblicherweise in den Projektionsgeräten eingesetzten Quecksilberlampen, wie etwa die Linien bei 334 nm, 365 nm und 405 nm. Die 4-Sulfonsäureester verfügen über Absorptionsmaxima bei ca. 380 nm und um 300 nm und sind daher mehr

für mittlere bis kurzwelligere UV-Strahlung geeignet, beispielsweise die Quecksilberemissionslinie bei 313 nm. Die Chinondiazidverbindungen sind in Positiv-Fotoresists üblicherweise in einem Anteil von etwa 5-50 Gew.%, bezogen auf den Gesamtfeststoffgehalt der Fotoresist-Lösung, enthalten.

Andere Chinondiazidverbindungen, die verwendet werden können, sind zum Beispiel monomere und dimere 2-Diazo-1,3-diketone, α-Phosphoryldiazocarbonylverbindungen sowie Benzochinondiazid-Derivate.

Als Lösungsmittel zur Herstellung der Fotoresist-Lösung sind im Prinzip alle Lösungsmittel geeignet, in denen die festen Fotoresist-Bestandteile wie alkalilösliches Harz, Chinondiazidverbindungen und gegebenenfalls weitere Zusatzstoffe ausreichend löslich sind und die mit diesen Bestandteilen nicht irreversibel reagieren. In Frage kommen hierfür beispielsweise aliphatische Ketone wie Methylethylketon oder Cyclohexanon, aliphatische Ester wie Butylacetat, Ether wie Tetrahydrofuran, Alkohole wie n- oder i-Propanol, Mono- oder Bisether sowie gemischte Ether-Esterderivate von Glycolverbindungen wie von Ethylenglycol, Diethylenglycol oder Propylenglycol, des weiteren Monooxocarbonsäureester wie etwa Milchsäureethylester oder 2-Ethoxypropionsäureethylester. Aliphatische und aromatische Kohlenwasserstoffe wie n-Hexan und Xylol finden ebenfalls Verwendung als Lösungsmittel. Vielfach werden auch Gemische aus den genannten Lösungsmitteln verwendet. Verbreitet enthalten Fotoresist-Lösungsmittel Ethoxyethylacetat, Propylenglycolmethyletheracetat oder Ethylenglycoldimethylether. Das Lösungsmittel hat überlicherweise einen Anteil von 40-90 Gew.% an der gesamten Fotoresist-Lösung.

Zu den weiteren üblichen Zusatzstoffen, die auch in den erfindungsgemäßen Fotoresist-Zusammensetzungen enthalten sein können, gehören etwa streustrahlungsabsorbierende Substanzen und Farbstoffe, Verlaufmittel, Weichmacher, Haftvermitter, weitere filmbildende Harze, Entwicklungsbeschleuniger, Tenside und Stabilisatoren. Zusätze dieser Kategorien sind dem Fachmann ausreichend bekannt und sind vielfältig in der einschlägigen Fachliteratur beschrieben. Der Anteil an solchen Zusatzen übersteigt zusammengenommen kaum 25 Gew.%, bezogen auf den Gesamtfeststoffgehalt der Fotoresist-Lösung.

Die erfindungsgemäßen Fotoresist-Zusammensetzungen enthalten typischerweise 50-90 Gew.%, vorzugsweise 70-80 Gew.%, an alkalilöslichem Harz, 5-25 Gew.%, vorzugsweise 10-15 Gew.%, an Chinondiazidverbindungen, 2-25 Gew.%, vorzugsweise 5-15 Gew.%, an Verbindungen der Formel I und 0-25 Gew.%, vorzugsweise 5-10 Gew.%, an sonstigen Zusatzstoffen, jeweils bezogen auf den Gesamtfeststoffgehalt.

Die Formulierung der erfindungsgemäßen Positiv-Fotoresist-Zusammensetzungen erfolgt in an sich bekannter Weise durch Mischen bzw. Lösen der Komponenten in dem Lösungsmittel bzw. Lösungsmittelgemisch, wobei die erfindungsgemäß einzusetzenden Verbindungen der Formel I zugesetzt werden. Gleichermaßen ist es möglich, fertigformulierte Positiv-Fotoresist-Zusammensetzungen, wie sie etwa im Handel sind, mit der entsprechenden Menge an Verbindungen der Formel I zu versetzen. Nach Lösung der Bestandteile im Lösungsmittel wird die erhaltene Fotoresist-Lösung je nach Anspruch an die Partikelfreiheit durch Membranfilter mit einer Porenweite von 0,1-1 µm filtriert. Üblichweise wird der Gesamtfeststoffgehalt des Fotoresist auf die gewünschte Schichtdicke und Beschichtungsmethode abgestimmt.

Die Anwendung der erfindungsgemäßen Positiv-Fotoresist-Zusammensetzungen erfolgt nach an sich bekannten Verfahren und mit den hierfur üblichen Prozeßgeräten. Zunächst wird die Fotoresist-Lösung auf das Substrat aufgebracht und getrocknet. Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere, bei der Herstellung miniaturisierter Schaltungen übliche Materialien wie Germanium, Galliumarsenid, Keramik mit gegebenenfalls Edelmetallbeschichtung kommen in Frage.

Die Beschichtung erfolgt üblicherweise durch Tauchen, Sprühen, Walzen oder Aufschleudern. Bei der letzteren, am häufigsten angewandten Beschichtungsmethode ist die resultierende Schichtdicke abhängig von der Viskosität der Fotoresist-Lösung, dem Feststoffgehalt und der Aufschleudergeschwindigkeit. Für den jeweiligen Fotoresist werden sogenannte Schleuderkurven ermittelt, aus denen sich die Resist-Schichtdicken in Abhängigkeit von Viskosität und Schleuderdrehzahl ermitteln lassen. Die Schichtdicken bei Positiv-Fotoresists liegen typisch im Bereich von 0,5-4 µm.

Nachdem der Fotoresist auf das Substrat aufgebracht worden ist, wird er normalerweise bei Temperaturen zwischen 70 °C und 130 °C vorgetrocknet. Dazu können Öfen oder Heizplatten (sogenannte "Hot Plates") verwendet werden. Die Trocknungszeit in Öfen liegt im Bereich von etwa 15-45 Minuten, auf Hot Plates im Bereich von etwa 0,5-4 Minuten. Vorzugsweise werden 0,5-2 µm dicke Resistschichten etwa 1 Minute bei etwa 100 °C auf der Hot Plate getrocknet.

Der getrocknete Fotoresist wird dann durch eine Maske hindurch bildmäßig belichtet, wobei Strahlung mit einer Wellenlänge im Bereich von etwa 300 nm bis 450 nm verwendet wird. Die Belichtung kann poly- oder monochromatisch erfolgen. Bevorzugt werden hierzu kommerziell erhältliche Geräte, wie z.B. Scanning-Projektions-Belichtungsgeräte, Kontakt- und Abstands-Belichtungsgeräte oder Wafer-Stepper eingesetzt.

Die mit dem Fotoresist beschichteten und belichteten Substrate werden schließlich mit einer wäßrig-alkalischen Entwicklerlösung, z.B. durch Tauchen oder Besprühen, entwickelt, bis in den belichteten Bereichen der Resist vollständig abgelöst ist. Es können verschiedene Entwicklerformulierungen verwendet werden, die entweder zur Klasse der metallionenhaltigen oder metallionenfreien Fotoresistentwickler gehören. Metallionenhaltige Entwickler sind wäßrige Lösungen von Natriumhydroxyd oder Kaliumhydroxid, die daüber hinaus pH-regulierende und puffernde Substanzen, wie Phosphate oder Silikate sowie Tenside und Stabilisatoren enthalten können. Metallionenfreie Entwickler sind wäßrige Lösungen von organischen Basen, wie z.B. Tetramethylammoniumhydroxyd oder Cholin. Die Entwicklungszeiten hängen von der Belichtungsenergie, Stärke des Entwicklers, Art des Entwickelns, der Vortrocknungstemperatur und der Entwicklertemperatur ab. Bei der Tauchentwicklung sind Entwicklungszeiten von etwa 1 Minute typisch. Die Entwicklung wird üblicherweise durch Eintauchen oder Besprühen mit deionisiertem Wasser gestoppt. An die Entwicklung schließt sich häufig eine Nachtrocknung bei etwa 120 °C bis 180 °C an.

Die mit den erfindungsgemäßen Fotoresist-Zusammensetzungen hergestellten Reliefstrukturen zeigen eine vorzügliche Bildauflösung bis unter 1 µm bei hohem Kontrast, hoher Kantensteilheit und Kantenschärfe. Der Schichtdickenverlust in den unbelichteten Bereichen ist minimal. In den nachfolgenden Prozeßabläufen bei der Herstellung von integrierten Halbleiterschaltungen wie Ätzen mit Säure oder im Plasma, Dotieren oder Beschichten, zeigen sie hervorragende Eigenschaften und gewährleisten einen wirksamen Schutz der mit den Fotoresist-Reliefstrukturen abgedeckten Bereiche des Schichtträgers.

## Beispiele und Vergleichsversuche

### Fotoresist-Formulierungen

Eine Fotoresist-Stammlösung wurde folgendermaßen hergestellt:
In 827 g einer 31,7%igen m-Kresol-Novolak-Lösung in Diethylenglykoldimethylether wurden 52 g eines Naphthochinondiazids, das durch Veresterung von 1,2-Naphthochinon-2-diazid-5-sulfonylchlorid mit 1,3,5-Trihydroxybenzol erhalten worden war, gelöst und mit Diethylenglykoldimethylether eine Viskosität von 30 cSt eingestellt. Die Lösung wurde durch ein Filter mit 0,2 µm Porenweite filtriert.

Proben dieser Stammlösung wurden jeweils 4,0 Gew.% (entsprechend 12,8 Gew.%, bezogen auf den Gesamtfeststoffgehalt) an erfindungsgemäßen Additiven zugesetzt. Von den zwei Vergleichslösungen enthielt eine keinerlei Additiv, die andere 4,0 Gew.% 2,3,4-Trihydroxybenzophenon (bekannt aus US-Patent 4,262,492). Alle Formulierungen wurden nochmals filtriert.

### Versuchsmethodik

Die Fotoresist-Formulierungen wurden auf oberflächlich oxidierte Silizium-Scheiben von 4" Durchmesser bei einer Drehzahl von etwa 5000 $min^{-1}$ aufgeschleudert, so daß nach dem Trocknen auf der Hot Plate für 1 Minute bei 100 °C eine Schichtdicke von 1,17 µm resultierte.

Die Belichtung erfolgte monochromatisch oder polychromatisch durch eine Testmaske abgestufter Duchlässigkeit (Optoline Multi-Density-Mask), wobei die Belichtungsenergien mit einer Meßsonde registriert wurden.

Entwickelt wurde durch Tauchentwicklung bei 20,4 °C in einem metallionenfreien Entwickler (Selectiplast PD 2006, E. Merck) mit einem Gehalt von 1,8 Gew.% Tetramethylammoniumhydroxid (TMAH), wobei die Schichtdicken laserinterferometrisch mit einem Entwicklungsratenmonitor (Perkin-Elmer DRM) gemessen wurden.

Anhand der erhaltenen Daten für Belichtungsenergie und Schichtdicke wird eine Kontrastkurve aufgetragen, wie in "Introduction to Microlithography" von G.C. Willson, Kapitel 3, S. 105, American Chemical Society, Washington, D.C., 1983, beschrieben. Dazu wird der Schichtdikkenverlust nach einminütigem Entwickeln gegen den Logarithmus der UV-Belichtungsdosis aufgetragen. Durch Extrapolation der Kurve auf verschwindende Restschichtdicke erhält man die Mindestbelichtungsenergie $E_0$ ($mJ/cm^2$), die Steigung dieser Kurve gibt den Kontrast $\gamma$ an. Außerdem wurde nach 60 Sekunden Entwicklungszeit der Schichtdikkenabtrag (Dunkelabtrag) $\Delta$ d (nm) in den unbelichteten Bereichen gemessen.

### Beispiel 1

Die Belichtung erfolgte monochromatisch bei 365 (± 5) nm.
Die Ergebnisse zeigt Tabelle 1.

Das erfindungsgemäße Additiv bewirkt gegenüber der Vergleichsformulierung ohne jegliches Additiv im brauchbaren Fall eine Reduktion der Mindestbelichtungsenergie um über 70 %.

Gegenüber dem bekannten Additiv ist die Mindestbelichtungsenergie um 40 % reduziert, der Kontrast um 15 % erhöht und der Dunkelabtrag um 50 % vermindert.

Tabelle 1

| Additiv | Mindestbelichtungsenergie $E_0$ ($mJ/cm^2$) | Kontrast $\gamma$ | Dunkelabtrag $\Delta d$ (nm) |
|---|---|---|---|
| Vergleich | | | |
| - | > 200 | - | - 1) |
| - | 93 | 1,8 | 37 2) |
| 2,3,4-Trihydroxybenzophenon | 44,9 | 2,0 | 40 |
| erfindungsgemäß | | | |
| Bis(4-hydroxyphenyl)sulfon | 22,7 | 2,3 | 20 |

1) nicht brauchbar

2) Entwicklung in 2,0 % TMAH

Beispiel 2

Die Belichtung erfolgte polychromatisch im nahen UV-Bereich (Suess MA 56 Mask Aligner, Hg-g-, h- und i-Linien); die Belichtungsenergie wurde mit einer 365 nm-Sonde gemessen.

Die Ergebnisse zeigt Tabelle 2.

Gegenüber dem bekannten Additiv bewirken 4 der 7 erfindungsgemäßen Additive eine Reduktion der Mindestbelichtungsenergie um bis zu 47 %; gleichzeitig wird der Kontrast um bis zu 45 % gesteigert und der Dunkelabtrag um bis zu 67 % vermindert. Bei 3 der Additive ist zwar die Mindestbelichtungsenergie geringfügig erhoht; diese Additive zeigen aber bei Kontrast und Dunkelabtrag besonders günstige Werte.

Tabelle 2

| Additiv | Mindest-belichtungs-energie $E_0$ ($mJ/cm^2$) | Kontrast $\gamma$ | Dunkel-abtrag $\Delta d$ (nm) |
|---|---|---|---|
| **Vergleich** | | | |
| 2,3,4-Trihydroxy-benzophenon | 15,3 | 2,7 | 30 |
| **erfindungsgemäß** | | | |
| 4,4'-Dihydroxy-biphenyl | 14,2 | 3,6 | 24 |
| 2,2'-Dihydroxy-biphenyl | 15,9 | 3,9 | 10 |
| 4,4'-Dihydroxy-benzophenon | 8,1 | 3,6 | 20 |
| Bis(4-hydroxy-phenyl)ether | 15,9 | 3,8 | 12 |
| Bis(4-hydroxy-phenyl)sulfid | 15,8 | 3,6 | 10 |
| Bis(2,4-dihydroxy-phenyl)sulfid | 8,2 | 3,5 | 30 |
| 2,2-Bis(4-hydroxy-phenyl)propan | 14,2 | 2,8 | 10 |
| 2,2-Bis(4-hydroxy-phenyl)-1,1,1,3,3,3-hexafluorpropan | 16,5 | 2,9 | 8 |

## Patentansprüche

## Patentansprüche für folgende Vertragsstaaten : CH, DE, FR, GB, IT, LI, NL

**1.** Positiv-Fotoresist-Zusammensetzungen, enthaltend in einem organischen Lösungsmittel im wesentlichen mindestens je

a) ein alkalilösliches Harz

b) eine fotoempfindliche Chinondiazid-Verbindung

c) eine die Fotoempfindlichkeit und/oder die Entwicklungsrate steigernde aromatische Hydroxyverbindung

sowie gegebenenfalls weitere übliche Zusatzstoffe, dadurch gekennzeichnet, daß als aromatische

Hydroxyverbindung eine Verbindung der Formel I

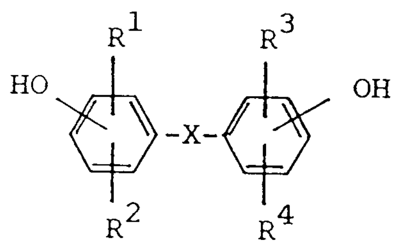

(I)

enthalten ist, worin

X eine Einfachbindung, -O-, -S-, $SO_2$, CO,

$R^1$, $R^2$, $R^3$ und $R^4$ jeweils H, Halogen, $C_{1-4}$-Alkyl, $C_{1-4}$-Alkoxy oder OH bedeuten, und wobei alle Trihydroxybenzophenon-Verbindungen sowie 4,4'-Dihydroxybiphenyl, 4,4'-Dihydroxybenzophenon, Bis-(4-hydroxyphenyl)sulfid und Bis(4-hydroxyphenyl)sulfon ausgenommen sind.

**2.** Positiv-Fotoresist-Zusammensetzungen nach Anspruch 1, dadurch gekennzeichnet, daß darin die Verbindung(en) der Formel I in einem Anteil von 2-25 Gew.%, bezogen auf den Gesamtfeststoffgehalt, enthalten ist (sind).

**3.** Positiv-Fotoresist-Zusammensetzung nach Anspruch 1, dadurch gekennzeichnet, daß darin als Verbindung der Formel I mindestens eine Verbindung aus der Gruppe

2,2'-Dihydroxybiphenyl,
Bis(4-hydroxyphenyl)ether,
Bis(2,4-dihydroxyphenyl)sulfid

enthalten ist.

**4.** Verwendung von Verbindungen der Formel I

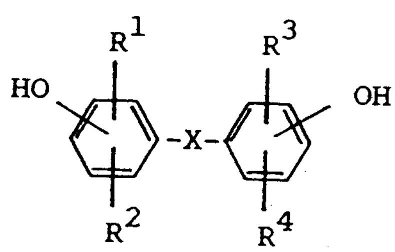

(I),

worin

X eine Einfachbindung, -O-, -S-, -($SO_2$)-, -(CO)-,

$R^1$, $R^2$, $R^3$und $R^4$ jeweils H, Halogen, $C_{1-4}$-Alkyl, $C_{1-4}$-Alkoxy oder OH bedeuten und wobei alle Trihydroxybenzophenon-Verbindungen ausgenommen sind,

als Additive zur Steigerung des Kontrasts in Positiv-Fotoresist-Zusammensetzungen auf Basis alkalilöslicher Harze und lichtempfindlicher Chinondiazid-Verbindungen.

**5.** Verwendung nach Anspruch 4 von

4,4'-Dihydroxybiphenyl,
2,2'-Dihydroxybiphenyl,
4,4'-Dihydroxybenzophenon,
Bis(4-hydroxyphenyl)ether,
Bis(4-hydroxyphenyl)sulfid,
Bis(2,4)-dihydroxyphenyl)sulfid,
Bis(4-hydroxyphenyl)sulfon.

**Patentansprüche für folgende Vertragsstaaten : AT, SE**

1. Positiv-Fotoresist-Zusammensetzungen, enthaltend in einem organischen Lösungsmittel im wesentlichen mindestens je
   a) ein alkalilösliches Harz
   b) eine fotoempfindliche Chinondiazid-Verbindung
   c) eine die Fotoempfindlichkeit und/oder die Entwicklungsrate steigernde aromatische Hydroxyverbindung

   sowie gegebenenfalls weitere übliche Zusatzstoffe, dadurch gekennzeichnet, daß als aromatische Hydroxyverbindung eine Verbindung der Formel I

   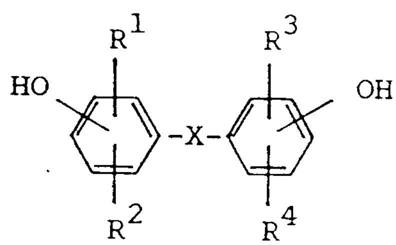

   (I)

   enthalten ist, worin
   X eine Einfachbindung, -O-, -S-, $SO_2$, CO,
   $R^1$, $R^2$, $R^3$ und $R^4$ jeweils H, Halogen, $C_{1-4}$-Alkyl, $C_{1-4}$-Alkoxy oder OH bedeuten, und wobei alle Trihydroxybenzophenon-verbindungen ausgenommen sind.

2. Positiv-Fotoresist-Zusammensetzungen nach Anspruch 1, dadurch gekennzeichnet, daß darin die Verbindung(en) der Formel I in einem Anteil von 2-25 Gew.%, bezogen auf den Gesamtfeststoffgehalt, enthalten ist (sind).

3. Positiv-Fotoresist-Zusammensetzung nach Anspruch 1, dadurch gekennzeichnet, daß darin als Verbindung der Formel I mindestens eine Verbindung aus der Gruppe
   4,4'-Dihydroxybiphenyl
   2,2'-Dihydroxybiphenyl
   4,4'-Dihydroxybenzophenon
   Bis(4-hydroxyphenyl)ether
   Bis(4-hydroxyphenyl)sulfid
   Bis(2,4)-dihydroxyphenyl)sulfid
   Bis(4-hydroxyphenyl)sulfon

   enthalten ist.

4. Verwendung von Verbindungen der Formel I als Additive zur Steigerung der Fotoempfindlichkeit und/oder der Entwicklungsrate in Positiv-Fotoresist-Zusammensetzungen auf Basis alkalilöslicher Harze und lichtempfindlicher Chinondiazid-Verbindungen.

**Claims**

**Claims for the following Contracting States : CH, DE, FR, GB, IT, LI, NL**

1. Positive photoresist compositions containing, in an organic solvent, essentially at least one each of
   a) an alkali-soluble resin,
   b) a photosensitive quinone diazide compound,
   c) an aromatic hydroxy compound which increases the photospeed and/or the rate of development,

   and also, optionally, other usual additives, characterized in that a compound of the formula I

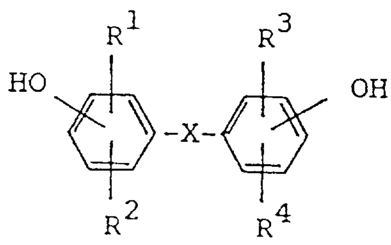

(I)

in which

X is a single bond, -O-, -S-, $SO_2$ or CO, and

$R^1$, $R^2$, $R^3$ and $R^4$ are in each case H, halogen, $C_{1-4}$-alkyl, $C_{1-4}$-alkoxy or OH, with the exclusion of all trihydroxybenzophenone compounds and of 4,4'-dihydroxybiphenyl, 4,4'-dihydroxybenzophenone, bis(4-hydroxyphenyl) sulfide and bis(4-hydroxyphenyl) sulfone,

is contained as aromatic hydroxy compound.

**2.** Positive photoresist compositions according to claim 1, characterized in that the compound(s) of the formula I is (are) contained therein in a proportion of 2-25% by weight, referred to the total solids content.

**3.** Positive photoresist composition according to claim 1, characterized in that at least one compound from the group comprising
2,2'-dihydroxybiphenyl,
bis(4-hydroxyphenyl) ether and
bis(2,4-dihydroxyphenyl) sulfide
is contained therein as compound of the formula I.

**4.** Use of compounds of the formula I

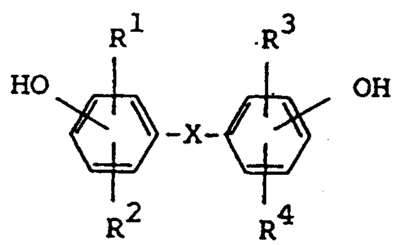

(I),

in which

X is a single bond, -O-, -S-, $-(SO_2)-$ or -(CO)- and
$R^1$, $R^2$, $R^3$ and $R_4$ are in each case H, halogen, $C_{1-4}$-alkyl, $C_{1-4}$-alkoxy or OH, with the exclusion of all trihydroxybenzophenone compounds, as additives for increasing the contrast in positive photoresist compositions based on alkali-soluble resins and photosensitive quinone diazide compounds.

**5.** Use according to claim 4 of
4,4'-dihydroxybiphenyl,
2,2'-dihydroxybiphenyl,
4,4'-dihydroxybenzophenone,
bis(4-hydroxyphenyl) ether,
bis(4-hydroxyphenyl) sulfide,
bis(2,4-dihydroxyphenyl) sulfide and
bis(4-hydroxyphenyl) sulfone.

**Claims for the following Contracting States : AT, SE**

1. Positive photoresist compositions containing, in an organic solvent, essentially at least one each of
   a) an alkali-soluble resin,
   b) a photosensitive quinone diazide compound,
   c) an aromatic hydroxy compound which increases the photospeed and/or the rate of development,
   and also, optionally, other usual additives, characterized in that a compound of the formula I

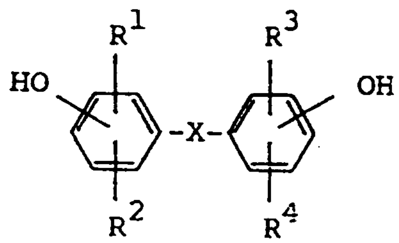

(I)

in which

X is a single bond, -O-, -S-, $SO_2$ or CO, and

$R^1$, $R^2$, $R^3$ and $R^4$ are in each case H, halogen, $C_{1-4}$-alkyl; $C_{1-4}$-alkoxy or OH, with the exclusion of all trihydroxybenzophenone compounds, is contained as aromatic hydroxy compound.

2. Positive photoresist compositions according to claim 1, characterized in that the compound(s) of the formula I is (are) contained therein in a proportion of 2-25% by weight, referred to the total solids content.

3. Positive photoresist composition according to claim 1, characterized in that at least one compound from the group comprising
   4,4'-dihydroxybiphenyl,
   2,2'-dihydroxybiphenyl,
   4,4'-dihydroxybenzophenone,
   bis(4-hydroxyphenyl) ether,
   bis(4-hydroxyphenyl) sulfide,
   bis(2,4-dihydroxyphenyl) sulfide and
   bis(4-hydroxyphenyl) sulfone
   is contained therein as compound of the formula I.

4. Use of compounds of the formula I as additives for increasing the photospeed and/or the rate of development in positive photoresist compositions based on alkali-soluble resins and photosensitive quinone diazide compounds.

**Revendications**

**Revendications pour les Etats contractants suivants : CH, DE, FR, GB, IT, LI, NL**

1. Compositions de photoréserves positives, contenant dans un solvant organique essentiellement au moins l'un des constituants suivants :
   a) une résine soluble dans les alcalis,
   b) un composé quinonediazide photosensible,
   c) un composé hydroxylé aromatique augmentant la photosensibilité et/ou la vitesse de développement,
   et éventuellement d'autres additifs usuels, caractérisées en ce qu'elles contiennent en tant que composés hydroxylés aromatiques un composé de formule

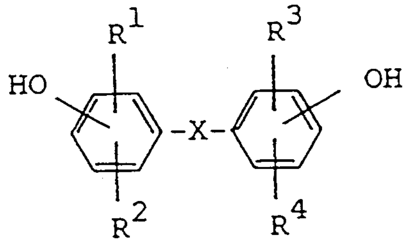

(I)

dans laquelle

X est une liaison simple, -O-, -S-, $SO_2$ ou CO,

$R^1$, $R^2$, $R^3$ et $R^4$ sont chacun H ou un radical halogéno, alkyle en $C_{1-4}$, alcoxy en $C_{1-4}$ ou OH, à l'exception de toutes les trihydroxybenzophénones, ainsi que des composés 4,4'-dihydroxybiphényle, 4,4'-dihydroxybenzophénone, sulfure de bis(4-hydroxyphényle) et bis(4-hydroxyphényl)sulfone.

**2.** Compositions de photoréserves positives selon la revendication 1, caractérisées en ce que le ou les composés qu'elles contiennent sont présents en une quantité de 2 à 25 % en poids par rapport à la teneur totale en extrait sec.

**3.** Compositions de photoréserves positives selon la revendication 1, caractérisées en ce qu'elles contiennent comme composé de formule I au moins un composé choisi parmi l'ensemble comprenant le 2,2'-dihydroxybiphényle, l'oxyde de bis(4-hydroxyphényle, le sulfure de bis(2,4-dihydroxyphényle).

**4.** Utilisation de composés de formule I

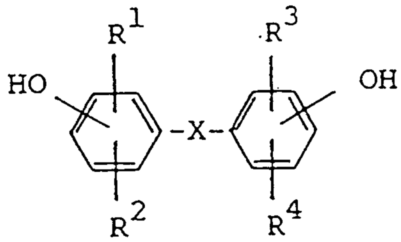

(I),

dans laquelle X est une liaison simple, -O-, -S-, $-(SO_2)-$, -(CO)-,

$R^1$, $R^2$, $R^3$ et $R^4$ sont chacun H ou un radical halogéno, alkyle en $C_{1-4}$, alcoxy en $C_{1-4}$ ou OH, à l'exception de toutes les trihydroxybenzophénones,

en tant qu'additifs pour augmenter le contraste dans les compositions de photoréserves positives à base de résines solubles dans les alcalis et de composés quinonediazides photosensibles.

**5.** Utilisation selon la revendication 4 des composés suivants :

4,4'-dihydroxybiphényle,
2,2'-dihydroxybiphényle,
4,4'-dihydroxybenzophénone,
oxyde de bis(4-hydroxyphényle),
sulfure de bis(4-hydroxyphényle),
sulfure de bis(2,4-dihydroxyphényle),
bis(4-hydroxyphényl)sulfone.

**Revendications pour les Etats contractants suivants : AT, SE**

**1.** Compositions de photoréserves positives, contenant dans un solvant organique essentiellement au moins l'un des constituants suivants :

a) une résine soluble dans les alcalis,
b) un composé quinonediazide photosensible,

c) un composé hydroxylé aromatique augmentant la photosensibilité et/ou la vitesse de développement,

et éventuellement d'autres additifs usuels, caractérisées en ce qu'elles contiennent en tant que composés hydroxylés aromatiques un composé de formule

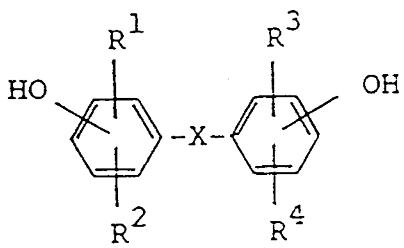

(I)

dans laquelle

X est une liaison simple, -O-, -S-, $SO_2$ ou CO,

$R^1$, $R^2$, $R^3$ et $R^4$ sont chacun H ou un radical halogéno, alkyle en $C_{1-4}$, alcoxy en $C_{1-4}$ ou OH, à l'exception de toutes les trihydroxybenzophénones.

**2.** Compositions de photoréserves positives selon la revendication 1, caractérisées en ce que le ou les composés qu'elles contiennent sont présents en une quantité de 2 à 25 % en poids par rapport à la teneur totale en extrait sec.

**3.** Compositions de photoréserves positives selon la revendication 1, caractérisée en ce que le composé de formule I qui s'y trouve est au moins un composé choisi parmi l'ensemble comprenant les groupes suivants :

4,4'-dihydroxybiphényle,
2,2'-dihydroxybiphényle,
4,4'-dihydroxybenzophénone,
oxyde de bis(4-hydroxyphényle),
sulfure de bis(4-hydroxyphényle),
sulfure de bis(2,4-dihydroxyphényle),
bis(4-hydroxyphényl)sulfone.

**4.** Utilisation de composés de formule I en tant qu'additifs pour augmenter la photosensibilité et/ou la vitesse de développement dans des compositions de photoréserves positives à base de résines solubles dans les alcalis et de composés quinonediazides photosensibles.